# EUROPÄISCHE PATENTSCHRIFT

(11) **EP 2 871 018 B1**
(45) Veröffentlichungstag und Bekanntmachung des Hinweises auf die Patenterteilung: **24.08.2016**
(21) Anmeldenummer: 14186548.5
(22) Anmeldetag: 26.09.2014
(51) Int. Cl.: B23K 1/008, B23K 1/06, H05K 3/34

(54) **Verfahren zur Voidminimierung beim Löten von Leiterplatten und Lötvorrichtung zu seiner Durchführung**
Method for void reduction when soldering circuit boards and soldering device for performing the same
Procédé de réduction de porosité pour le brasage de cartes de circuit imprimé et dispositif de brasage pour sa réalisation

(30) Priorität: 11.11.2013 DE 102013112367
(43) Veröffentlichungstag der Anmeldung: 13.05.2015
(73) Patentinhaber: Ersa GmbH, 97877 Wertheim (DE)
(72) Erfinder: Rawinski, Viktoria, 97828 Marktheidenfeld (DE)
(74) Vertreter: DREISS Patentanwälte PartG mbB

(56) Entgegenhaltungen:
- DE-B4-102004 036 521
- JP-A- 2003 188 515

## Beschreibung

Die Erfindung betrifft ein Verfahren zur Voidminimierung beim Löten von Leiterplatten nach dem Oberbegriff des Anspruchs 1 und eine Vorrichtung zu seiner Durchführung nach dem Oberbegriff des Anspruchs 12.

Aus dem Stand der Technik sind verschiedene Verfahren sowie Lötvorrichtungen zum Löten von mit elektrischen und/oder elektronischen Bauteilen bestückten Leiterplatten bekannt, wobei insbesondere bei auf der Oberfläche der Leiterplatte angeordneten Bauteilen und hier wiederum insbesondere bei sogenannten SMDs ein Lot in festem Zustand zwischen Leiterplatte und dem jeweiligen Bauteil angeordnet ist. Durch eine entsprechende Heizeinrichtung wird in einer Lötanlage das Lot zunächst aufgeschmolzen und anschließend wieder abgekühlt, wodurch sich beim Erstarren des Lotes eine elektrisch leitende und mechanische Verbindung zwischen Leiterplatte und Bauteil ergibt.

Nachteilig bei diesen bekannten Lötverfahren ist, dass es häufig zur Bildung von Einschlüssen im Lot zwischen dem Bauteil und der Leiterplatte kommt. Die Bildung dieser sogenannten Voids, die in der Regel gasförmig sind, hängt in entscheidendem Maß von der Wahl der Lotpaste, dem Leiterplattensubstrat und den Lotparametern ab. Ursache für diese Voids sind in der Regel dabei das in der Lotpaste eingesetzte Flussmittel, der verwendete Lötstoplack und flüchtige Komponenten des Leiterplattensubstrates. Je nach Häufigkeit, Dimension und Position der Voids können diese Voids zu einem Versagen der Lötstelle und/oder der Bauteile führen, was gerade im Bereich der Leistungselektronik und im High End Bereich, wie der Luft- und Raumfahrt, zu unzulässigen Feldausfällen führen kann.

Um derartige Voids zu vermeiden oder zumindest zu verringern, ist es bekannt, in einer Druckkammer unter Unter- oder Überdruck zu löten. Beim Löten unter Unterdruck besteht jedoch insbesondere die Gefahr, dass in den Molekülketten oder in zwischen den Molekülketten befindlichen Mikrohohlräumen der Kunststoffgehäuse der Bauteile und des Leiterplattensubstrats eingelagertes Wasser in die Dampfphase übergeht und versucht zu entweichen. Dies kann zu einer Zerstörung der Kunststoffgehäuse der Bauteile und zu einer Delamination der Leiterplatten führen. Beim Löten unter Überdruck erfolgt keine Entfernung der Voids; vielmehr werden diese lediglich komprimiert und verkleinert, so dass bei späteren Temperaturwechselbelastungen der Lötverbindungen diese einer hohen mechanischen Belastung unterliegen, die zu einer Zerstörung der Lötverbindung führen kann.

Aus der DE 10 2004 036 521 B4 ist ferner ein Verfahren zur Herstellung einer Lötverbindung bekannt, bei dem Gaseinschlüsse im Lot dadurch verringert oder ausgetrieben werden sollen, dass zwei Lötpartner, zwischen denen aufgeschmolzenes Lot angeordnet ist, mittels eines Vibrators in Schwingungen versetzt werden. Dabei leitet der Schwingungsgeber die Schwingungen im wesentlichen transversal zur Bauteilebene ein, so dass die Bauteile insgesamt nach Art eines Rüttlers bewegt werden. Nachteilig dabei ist insbesondere, dass dies bei kleinen und kleinsten Bauteilen zu einer unerwünschten Dislozierung führen kann und die Entfernung der Gaseinschlüsse ohne zusätzliches Vakuum unzureichend ist.

Aus der JP 2003-188515A ist ein Verfahren zur Verbesserung der Benetzung von Lötverbindungen bei der Verwendung von bleifreien Loten bekannt. Die JP 2003-188515A offenbart zur Lösung dieses Problems ein Verfahren und eine Vorrichtung, mit der eine Leiterplatte mittels zweier an gegenüberliegenden Seitenkanten der Leiterplatte angeordneter Schwingungserreger oszillierend hin und her bewegt wird.

Ausgehend von diesem Stand der Technik ist es daher die Aufgabe der vorliegenden Erfindung, die vorbeschriebenen Nachteile zu verringern und die Voidbildung in den Lötstellen zu minimieren.

Diese Aufgabe wird durch ein Verfahren nach Anspruch 1 und eine Vorrichtung nach Anspruch 12 gelöst.

Vorteilhafte Ausführungsformen der Erfindung sind Gegenstand der Unteransprüche.

Vor der Durchführung des Verfahrens nach der vorliegenden Erfindung wird die Leiterplatte zunächst einmal mit den aufzulötenden Bauteilen bestückt, wobei zwischen den Bauteilen und der Leiterplatte jeweils ein Lotdepot angeordnet ist. Nach dem Einbringen in eine Lötanlage - dies wird in der Regel eine Lötanlage mit mindestens einer Lötkammer sein - erfolgt in dieser durch eine beliebige Heizvorrichtung erfindungsgemäß ein Aufschmelzen des Lotes. Während dieses Aufschmelzens oder danach, das heißt nachdem das Lot bereits vollständig aufgeschmolzen ist, wird die Leiterplatte mit einer mechanischen Schwingung beaufschlagt. Dabei wird die Frequenz der Schwingung zwischen einer Startfrequenz und einer Endfrequenz verändert.

Im Gegensatz zu den aus dem Stand der Technik bekannten Verfahren erfolgt die Einleitung der Schwingung in einer Richtung der Leiterplattenebene durch unmittelbare oder mittelbare Ankopplung mindestens eines Aktuators an mindestens einer Seitenkante der Leiterplatte. Diese stützt sich dabei mit ihrer der jeweils dem Aktuator gegenüberliegenden Seitenkante an einem Festanschlag nach Art eines Widerlagers ab.

Mit anderen Worten bedeutet dies zunächst einmal, dass die Schwingungen im Wesentlichen als Longitudinalwellen, bezogen auf die Leiterplattenebene, in die Leiterplatte eingeleitet werden. Durch die einander gegenüberliegende Anordnung, bezogen wiederum auf die Leiterplatte, von Aktuator und Festanschlag erfolgt also kein Rütteln der Leiterplatte sondern vielmehr in schneller Folge ein Komprimieren und Dekomprimieren des Leiterplattensubstrats. Dabei wird die Frequenz des Aktuators während des schmelzflüssigen Zustands des Lots zwischen einer Startfrequenz und einer Endfrequenz verändert. Die Schwingungen der Leiterplatte werden unmittelbar auf das aufgeschmolzene Lot und, gedämpft durch das schmelzflüssige Lot, auch auf die darüber angeordneten Bauteile übertragen. Durch die durch die schwingende Leiterplatte ins Lot übertragene Bewegungsenergie werden insbesondere gasförmige Einschlüsse - Voids - aus dem Lot vollständig oder zumindest teilweise ausgetrieben. Dadurch werden die Voids insgesamt verringert.

Dies begünstigt auch in erheblichem Maße den thermischen Übergang zwischen dem Bauteil und der Leiterplatte, welcher insbesondere bei Hochleitungselektronik einen wesentlichen Leistungsfaktor darstellt.

Der Aktuator kann erfindungsgemäß unmittelbar an einer Seitenkante der Leiterplatte zur Anlage gelangen oder aber unmittelbar, das heißt insbesondere über einen Leiterplattenrahmen, auf dem die Leiterplatte während des Lötvorgangs gehalten ist, oder eine Transportvorrichtung, wenn die Leiterplatte während des Lotvorgangs auf dieser durch die Lötanlage bewegt wird. Für den Festanschlag gilt, dass dieser in einer festen Position gegenüber der Leiterplatte angeordnet ist, so dass diese sich daran abstützen kann. Dabei kann dieser Festanschlag sowohl in fester Position in der Lötanlage angeordnet sein oder aber er kann vor der Betätigung des Aktuators in seine Anschlagsposition gebracht werden. Ebenso ist denkbar, dass während des Transports der Leiterplatte durch die Lötanlage der Festanschlag ebenso wie der Aktuator zusammen mit der Leiterplatte durch die Lötanlage bewegt werden.

Nach einem besonders bevorzugten Ausführungsbeispiel der Erfindung wird die Frequenz zwischen der Startfrequenz und der Endfrequenz schrittweise oder kontinuierlich nach Art eines Sweeps erhöht. Dabei kann diese Erhöhung linear, stufenförmig oder logarithmisch sein. Eine solchermaßen sweepartige Schwingung stellt dabei sicher, dass eine Vielzahl von Eigenfreqenzen angeregt wird, was zu einer besonders effektiven Übertragung der Schwingung von der Leiterplatte an das schmelzflüssige Lot und damit zur besonders effektiven Voidminimierung führt. Zudem erfolgt mit steigender Frequenz eine Erhöhung des E-Moduls des Leiterplattenmaterials und damit eine Versteifung der Leiterplatte, wodurch ebenfalls der Energieübertrag auf das flüssige Lot erhöht wird.

Um eine schonende und möglichst homogene Ausbreitung der Schwingungen im Substrat der Leiterplatte zu erreichen, ist es nach einem weiteren Ausführungsbeispiel vorgesehen, die Startfrequenz möglichst niedrig zu wählen. Die Zielfrequenz ist vorzugsweise so zu wählen, dass möglichst viele, im Idealfall sämtliche Eigenfrequenzen der Leiterplatte umfasst sind. Es hat sich gezeigt, dass bei einem Frequenzbereich zur Anregung der Leiterplatte zwischen 0 Hz und 15 kHz diese Forderungen für die meisten Leiterplattengeometrien und -größen nahezu ideal erfüllt sind. Besonders vorteilhaft ist es, mit einer Startfrequenz zwischen 0 Hz und 10 Hz zu beginnen und diese bis zur Endfrequenz zwischen 1 kHz und 15 kHz zu steigern. Damit kann mit einem Sweep das gesamte Resonanzspektrum nahezu jeder Leiterplatte, unabhängig von deren Geometrie und den darauf angeordneten Bauteilen, angeregt werden, so dass keine spezifischen Einstellungen für verschiedene Leiterplattengrößen vorgenommen werden müssen, wodurch sich Rüstzeiten reduzieren und aufwendige Steuer- und Regelungseinrichtungen eingespart werden können.

Die Form der Schwingung zur Anregung der Leiterplatte ist zunächst unerheblich, Es hat sich jedoch als besonders vorteilhaft erwiesen, wenn die Schwingung sinusförmig ausgebildet ist.

In grundsätzlich beliebiger Weise kann der Schwingungsverlauf zwischen Start- und Endfrequenz als ein einziger Zyklus ausgebildet sein, der sich zumindest über einen Abschnitt der Zeitdauer, in der das Lot schmelzflüssig ist, erstreckt. Nach einer weiteren Ausgestaltung der Erfindung werden jedoch zumindest zwei Zyklen nacheinander ausgeführt. Dies bedeutet, dass nach Erreichen der Endfrequenz in einem Zyklus der darauf folgende Zyklus wiederum mit der Startfrequenz beginnt. Dabei können die Zyklen hinsichtlich Start- und Endfrequenz identisch oder unterschiedlich sein.

Hierbei hat sich als vorteilhaft gezeigt, wenn die Dauer eines Zyklus zwischen 0,1 sec und 10 sec beträgt, während die Dauer sämtlicher Zyklen je Leiterplatte zusammen zwischen 10 sec und 120 sec beträgt. Besonders vorteilhaft ist eine Wahl für einen Zyklus mit einer Dauer zwischen 1 sec und 5 sec, wobei die Beaufschlagung mit der Schwingung insgesamt über einen Zeitraum von 10 sec bis 60 sec durchgeführt wird.

Die Ausführungsform mit kurzen Zyklen mit mehrfacher Wiederholung hat sich als besonders effektiv zur Reduzierung der Voids gezeigt, während es hingegen bei einem einzelnen Zyklus oder insbesondere auch bei einer konstanten Schwingungsanregung zur Aggregation von kleineren Voids zu einem großen Void kommen kann, welcher wiederum das Entweichen zwischen Bauteil und Leiterplatte erschwert.

Wenngleich sich die Schwingungsbeaufschlagung über einen Zeitraum bis circa 60 sec als besonders vorteilhaft gezeigt hat, ist es zur weiteren Reduzierung von Voids ebenso möglich, die Schwingungsbeaufschlagung während der gesamten Dauer des Lötprozesses, das heißt während die Lottemperatur oberhalb der Liquidustemperatur ist, durchzuführen.

Nach einem weiteren Ausführungsbeispiel der Erfindung liegt der Aktuator vor dem Beginn des Schwingungszyklus mit einer zumindest geringen Vorspannung mittelbar oder unmittelbar an der Leiterplatte an. Dies stellt sicher, dass während des gesamten Schwingungszyklus die Leiterplatte einer zumindest geringen Druckspannung unterliegt.

Die Höhe der Schwingungsamplitude ist grundsätzlich beliebig, solange zum Einen eine ausreichende Voidminimierung erreicht und zum Anderen eine mechanische Beschädigung der Leiterplatte zuverlässig ausgeschlossen wird. Als besonders vorteilhaft haben sich Amplituden zwischen 10 µm und 200 µm, insbesondere zwischen 50 µm und 100 µm, erwiesen.

Die erfindungsgemäße Lötvorrichtung zum Löten einer mit insbesondere elektrischen oder elektronischen Bauteilen bestückten Leiterplatte, die zur Durchführung des vorstehend beschriebenen Verfahrens geeignet ist, weist zunächst mindestens einen Lötbereich, mindestens eine im Lötbereich angeordnete Heizeinrichtung zum Aufschmelzen des zwischen den Bauteilen und der Leiterplatte befindlichen Lotes, mindestens einen Aktuator zur Einleitung mechanischer Schwingungen in die Leiterplatte und eine Steuereinrichtung zur Veränderung der Frequenz der Schwingungen des Aktuators auf. Der Lötbereich kann dabei, beispielsweise bei einer Reparaturlötstation, als offener Bereich nach Art eines Lötgestells oder aber, beispielsweise bei eine Reflowlötanlage, als Löt- oder Prozesskammer ausgebildet sein.

Erfindungsgemäß ist der Aktuator so ausgebildet und angeordnet, dass er im Bereich mindestens einer ersten Seitenkante der Leiterplatte an diese mittelbar oder unmittelbar derart zur Anlage bringbar ist, dass eine Schwingung in einer Richtung der Leiterplattenebene in die Leiterplatte einleitbar ist. Ferner ist ein widerlagerartiger Festanschlag vorgesehen, an den eine der ersten Seitenkante der Leiterplatte gegenüberliegende zweite Seitenkante der Leiterplatte sich abstützend zur Anlage bringbar ist.

Die Art des Aktuators oder Schwingungserzeugers ist grundsätzlich beliebig; Nach einem Ausführungsbeispiel der Erfindung weist jedoch der Aktuator einen piezoelektrischen Wandler, insbesondere einen Piezostapelwandler, einen Piezofaserwandler oder einen Piezokeramikwandler auf.

Alternativ dazu kann der Aktuator einen magnetostriktiven Wandler, einen Wandler aus einer magnetischen Formgedächtnislegierung und/oder eine elektromagnetische Schwingspule aufweisen.

Nach einer weiteren Ausführungsform der Erfindung ist eine Transportvorrichtung zum Transport der Leiterplatte in, durch und aus dem Lötbereich, insbesondere im Fall einer Lötkammer, vorgesehen. Dabei können der Aktuator und/oder der Festanschlag ortsfest im Lötbereich bzw. der Lötkammer angeordnet sein. Vorzugsweise jedoch sind dabei der Aktuator und/oder der Festanschlag zusammen mit der Leiterplatte oder zumindest synchron zu dieser in Transportrichtung bewegbar. Dadurch kann in einfacher Weise ein kontinuierlicher Betrieb der Lötanlage erreicht werden.

Weiter kann ein Transport- oder ein Leiterplattenrahmen zur Aufnahme der Leiterplatte während des Transports und/oder des Lötprozesses vorgesehen sein. Dabei kann die Ankopplung des Aktuators an die Leiterplatte unmittelbar durch direkten Kontakt oder aber mittelbar über die Transportvorrichtung, den Transport- oder den Leiterplattenrahmen erfolgen.

Auch die Abstützung der Leiterplatte am Festanschlag kann dabei mittelbar über die Transportvorrichtung, den Transport- oder den Leiterplattenrahmen erfolgen oder der Festanschlag kann durch den Transport- oder Leiterplattenrahmen gebildet werden.

Nachfolgend wird die Erfindung anhand lediglich Beispiele zeigender Zeichnungen näher erläutert. Es zeigen:
- **Fig. 1**: ein erstes Ausführungsbeispiel einer Anordnung einer mit Bauteilen bestückten Leiterplatte mit einem Schwingungserzeuger im Querschnitt;
- **Fig. 2**: ein zweites Ausführungsbeispiel einer Anordnung einer mit Bauteilen bestückten Leiterplatte mit einem Schwingungserzeuger im Querschnitt entlang der Schnittlinie A - A in Fig. 3;
- **Fig. 3**: das Ausführungsbeispiel nach Fig. 2 in Ansicht von oben;
- **Fig. 4**: ein drittes Ausführungsbeispiel einer Anordnung einer mit Bauteilen bestückten Leiterplatte mit einem Schwingungserzeuger in einer der Fig. 3 entsprechenden Ansicht von oben;
- **Fig. 5**: in schematischer Darstellung im Querschnitt die Lötverbindung zwischen einem Bauteil und der Leiterplatte mit vorhandenen Voids;
- **Fig. 6**: im Schnitt entlang der Schnittlinie B -B in Fig. 5 eine typische Verteilung von Voids in der Lötverbindung;
- **Fig. 7**: in einer der Fig. 5 entsprechenden Darstellung die Lötverbindung zwischen einem Bauteil und der Leiterplatte mit erfindungsgemäß reduzierten Voids;
- **Fig. 8**: in einer der Fig. 6 entsprechenden Darstellung entlang der Schnittlinie C - C in Fig. 7 die Lötverbindung mit erfindungsgemäß reduzierten Voids.

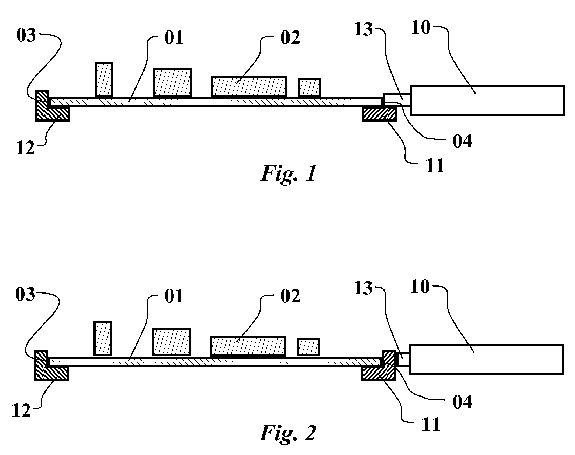

In der **Figur 1** wird in einem ersten Ausführungsbeispiel die Anordnung eines Schwingungserzeugers bzw. Aktuators 10 zur Schwingungsanregung einer Leiterplatte 01 schematisch dargestellt. Aus Gründen einer einfacheren und klareren Darstellung ist die Lötanlage, in der die Anordnung aus Leiterplatte und Aktuator angeordnet ist, nicht dargestellt.

Die mit elektronischen Bauteilen 02 bestückte Leiterplatte 01 liegt auf einem Trägerpaar 11 und 12 auf. Der Träger 12 ist dabei als im Querschnitt L-förmiger Winkel, an dessen vertikalen Schenkel eine Längskante 03 der Leiterplatte zur Anlage gelangt, ausgebildet. Der Träger 12 ist in nicht dargestellter Weise an einem Maschinengestell oder einem Gehäuse der Lötanlage im wesentlichen starr befestigt und bildet so einen Festanschlag für die Leiterplatte 01. Der dem Träger 12 gegenüberliegende Träger 11 bildet lediglich eine Auflage für die der Seitenkante 03 gegen-überliegende Seitenkante 04 der Leiterplatte 01, so dass diese nach Art eines Loslagers auf dem Träger 11 angeordnet ist.

Der Aktuator 10 ist mit seinem Schwinger 13 unmittelbar an die Längskante 04 der Leiterplatte 01 angekoppelt, das heißt dort zur Anlage gebracht. Dabei kann diese Anlage unter einer zumindest geringen Vorspannung erfolgen.

Wird nun der Aktuator 10 über eine nicht dargestellte Steuereinrichtung zum Schwingen angeregt, komprimiert und dekomprimiert der Schwinger 13 die Leiterplatte 01 in schneller Folge zwischen dem Aktuator 10 und dem als Festanschlag wirkenden Träger 12.

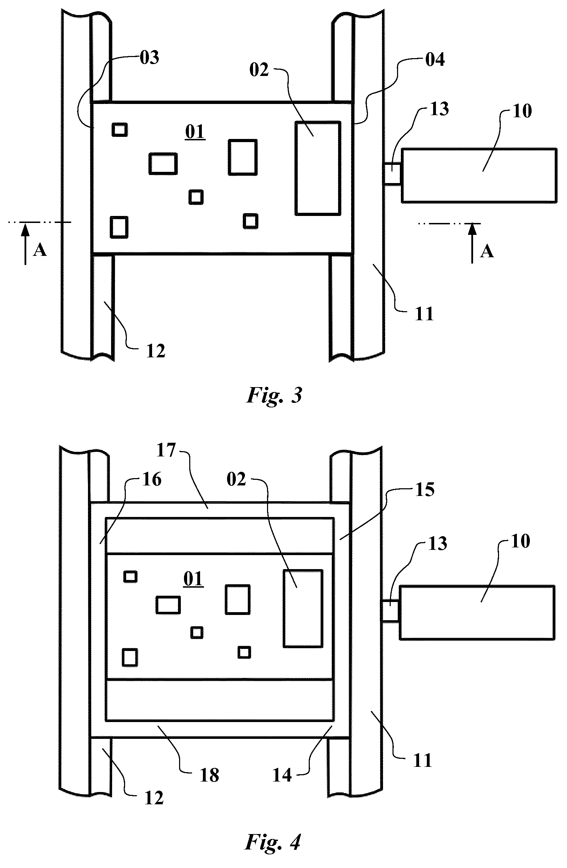

Bei dem in den **Figuren 2** **und** **3** dargestellten Ausführungsbeispiel der Erfindung sind die beiden Träger 11 und 12 Teil einer Transportvorrichtung zum Transport in oder durch die Lötkammer bzw. in oder durch den Lötbereich einer nicht dargestellten Lötanlage. Der Träger 12 bildet wiederum mit seinem vertikalen Schenkel einen Festanschlag für die Längskante 03 der Leiterplatte 01. Im Gegensatz zum in Fig. 1 dargestellte Ausführungsbeispiel ist auch der Träger 11 als im Querschnitt L-förmiger Winkel ausgebildet, an dessen vertikalen Schenkel die der Längskante 03 gegenüberliegende Längskante 04 der Leiterplatte zur Anlage gelangt. Dabei kann die Leiterplatte unter zumindest geringer Vorspannung zwischen den vertikalen Schenkeln der Träger 11 und 12 gehalten werden.

Der Schwinger 13 des Aktuators 10 liegt, gegebenenfalls unter Vorspannung, am vertikalen Schenkel des Trägers 12 und damit mittelbar an der Längskante 04 der Leiterplatte 01 an. Wird nun der Aktuator durch die Steuereinrichtung zum Schwingen angeregt, wird die Schwingung aufgrund entweder einer elastischen Verformbarkeit des Trägers 11 oder einer zumindest geringfügigen Beweglichkeit des Trägers 11 relativ zum Träger 12 mittelbar auf die Leiterplatte übertragen, wodurch diese wiederum in schneller Folge komprimiert und dekomprimiert wird.

Das in der **Figur 4** dargestellte Ausführungsbeispiel entspricht in seinem grundsätzlichen Aufbau dem Ausführungsbeispiel nach den **Figuren 2** **und** **3****.** Im Gegensatz zum vorherigen Ausführungsbeispiel, bei dem die Leiterplatte 01 unmittelbar auf den Trägern 11 und 12 der Transportvorrichtung aufliegt, ist beim Ausführungsbeispiel nach Fig. 4 die Leiterplatte 01 in einem Lötrahmen 14 angeordnet, in dem die Leiterplatte während ihres Transport durch die Lötvorrichtung bzw. Lötanlage an den Trägern 11 und 12 gehalten bzw. aufgelagert wird. Der Lötrahmen weist dabei zwei Querstreben 15 und 16 sowie zwei Längsstreben 17 und 18 auf. Dabei muss der Lötrahmen 14 so ausgestaltet und dimensioniert sein, dass bei der Einleitung von Schwingungen durch den Aktuator 10 mittelbar über den Träger 11 und die Querstreben 15 in die Leiterplatte 01 eine insbesondere elastische Verformbarkeit zumindest der Längsstreben 17 und 18 durch Kompression und/oder Biegung erfolgen kann, so dass die Leiterplatte erfindungsgemäß in schneller Folge komprimierbar und dekomprimierbar ist.

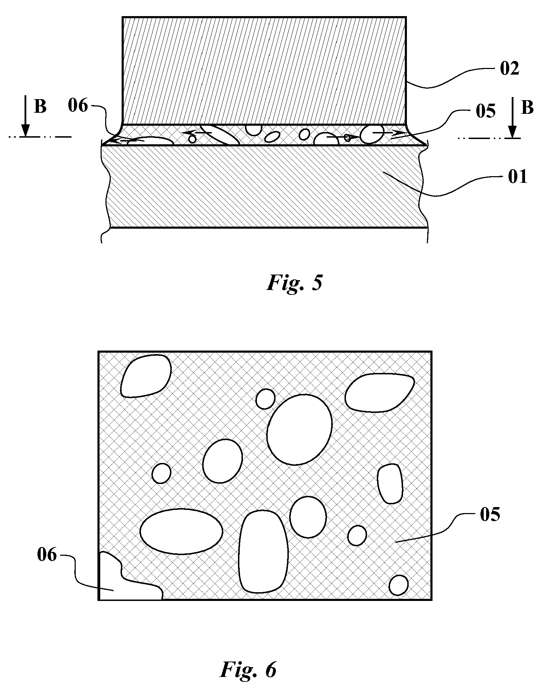

Zu Beginn der Schwingungsanregung befinden sich - wie **Figur 5** exemplarisch skizziert - zwischen dem Bauteil 02 und der Leiterplatte 01 im Lot 05 eine Vielzahl von Voids 06 in Form gasförmiger Einschlüsse, die einen nennenswerten Teil der Fläche ausmachen - siehe die mit Sicht auf die Leiterplattenebene exemplarisch skizzierte Lötverbindung in **Figur 6****.**

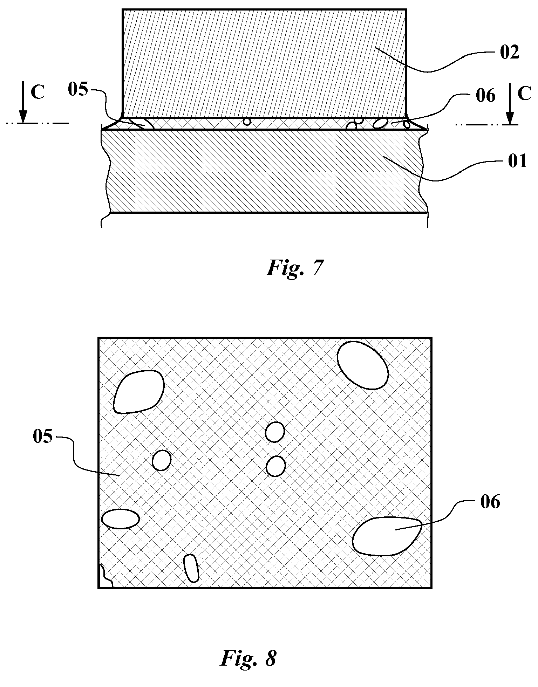

Aufgrund der Schwingungsanregung der Leiterplatte 01 wie vorstehend erläutert wird eine Bewegung der Voids 06 in dem flüssigen Lot 05 erzeugt, die bei Erreichen des Rands der Verbindung zwischen Bauteil 02 und Leiterplatte 01 aus dem schmelzflüssigen Lot 05 ausgetrieben werden. Dies hat zur Folge, dass sich die Anzahl der Voids 06 im Lot 05 nach durchgeführter Schwingungsanregung - wie dies exemplarisch die **Figuren 7 und 8** skizzieren - deutlich reduziert. Hierdurch wird eine erheblich verbesserte Qualität der Lötverbindung zwischen den Bauteilen 02 und der Leiterplatte 01 erreicht.

## Patentansprüche

1. Verfahren zur Voidminimierung beim Löten einer mit insbesondere elektrischen und/oder elektronischen Bauteilen (02) bestückten Leiterplatte (01), wobei während oder nach dem Aufschmelzen des zwischen den Bauteilen (02) und der Leiterplatte (01) befindlichen Lotes (05) diese mit einer mechanischen Schwingung beaufschlagt wird, wobei die Frequenz der Schwingung zwischen einer Startfrequenz und einer Endfrequenz verändert wird, wobei die Einleitung der Schwingung in einer Richtung der Leiterplattenebene durch unmittelbare oder mittelbare Ankopplung mindestens eines Aktuators (10) an mindestens einer Seitenkante (04) der Leiterplatte (01) erfolgt,
**dadurch gekennzeichnet, dass** sich die jeweils dem Aktuator (10) gegenüberliegende Seitenkante (03) der Leiterplatte (01) an einem Festanschlag (12) abstützt.

2. Verfahren nach Anspruch 1,
**dadurch gekennzeichnet,**
**dass** die Frequenz zwischen Startfrequenz und Endfrequenz schrittweise oder kontinuierlich erhöht wird.

3. Verfahren nach Anspruch 2,
**dadurch gekennzelchnet**,
dass die Frequenzerhöhung linear, stufenartig oder logarithmisch erfolgt.

4. Verfahren nach einem der Ansprüche 1 bis 3,
**dadurch gekennzeichnet,**
**dass** der Frequenzbereich zwischen Startfrequenz und Endfrequenz zwischen 0 Hz und 15 kHz liegt.

5. Verfahren nach einem der Ansprüche 1 bis 3,
**dadurch gekennzeichnet,**
**dass** die Schwingung sinusförmig ist.

6. Verfahren nach einem der Ansprüche 1 bis 5,
**dadurch gekennzeichnet,**
**dass** mindestens zwei Zyklen nacheinander durchgeführt werden.

7. Verfahren nach Anspruch 6,
**dadurch gekennzeichnet,**
**dass** die Dauer eines Zyklus zwischen 0,1 sec und 10 sec, insbesondere zwischen 1 sec und 5 sec, und die Dauer sämtlicher Zyklen insgesamt zwischen 10 sec und 120 sec, insbesondere zwischen 10 sec und 60 sec, beträgt.

8. Verfahren nach einem der Ansprüche 1 bis 7,
**dadurch gekennzeichnet,**
**dass** die Schwingungsbeaufschlagung im Wesentlichen während der gesamten Dauer des Lötprozesses erfolgt.

9. Verfahren nach einem der Ansprüche 1 bis 8,
**dadurch gekennzeichnet,**
**dass** die Einleitung der Schwingung über einen Schwingungserzeuger (10) mittelbar, insbesondere über einen Lötrahmen oder eine Transportvorrichtung, erfolgt.

10. Verfahren nach einem der Ansprüche 1 bis 9,
**dadurch gekennzeichnet,**
**dass** der Aktuator (10) vor dem Beginn des Schwingungszyklus mit einer zumindest geringen Vorspannung mittelbar oder unmittelbar an der Leiterplatte anliegt.

11. Verfahren nach einem der Ansprüche 1 bis 9,
**dadurch gekennzeichnet,**
**dass** die Schwingungsamplitude zwischen 10 µm und 200 µm beträgt.

12. Lötvorrichtung zum Löten einer mit insbesondere elektrischen oder elektronischen Bauteilen (02) bestückten Leiterplatte (01) mit mindestens einem Lötbereich, mit mindestens einer im Lötbereich angeordneten Heizeinrichtung zum Aufschmelzen des zwischen den Bauteilen (02) und der Leiterplatte (01) befindlichen Lotes (05), mit mindestens einem Aktuator (10) zur Einleitung mechanischer Schwingungen in die Leiterplatte (01) und einer Steuereinrichtung zur Veränderung der Frequenz der Schwingungen des Aktuators (10), wobei der Aktuator (10) im Bereich mindestens einer ersten Seitenkante (03) der Leiterplatte (01) an diese mittelbar oder unmittelbar derart zur Anlage bringbar ist, dass eine Schwingung in einer Richtung der Leiterplattenebene in die Leiterplatte (01) einleitbar ist,
**dadurch gekennzeichnet, dass** ein widerlagerartiger Festanschlag (12) vorgesehen ist, an den eine der ersten Seitenkante (03) der Leiterplatte (01) gegenüberliegende zweite Seitenkante (04) der Leiterplatte (01) sich abstützend zur Anlage bringbar ist.

13. Lötvorrichtung nach Anspruch 12,
**dadurch gekennzeichnet,**
**dass** der Aktuator (10) einen piezoelektrischen Wandler, insbesondere einen Piezostapelwandler, einen Piezofaserwandler oder einen Piezokeramikwandler aufweist.

14. Lötvorrichtung nach Anspruch 12,
**dadurch gekennzeichnet,**
**dass** der Aktuator (10) einen magnetostriktiven Wandler, einen Wandler aus einer magnetischen Formgedächtnislegierung und/oder eine elektromagnetische Schwingspule aufweist.

15. Lötvorrichtung nach einem der Ansprüche 12 bis 14,
**dadurch gekennzeichnet,**
**dass** die Lötvorrichtung als Reflow-Lötvorrichtung oder als Reparaturlötstation ausgebildet ist.

16. Lötvorrichtung nach einem der Ansprüche 12 bis 15,
**dadurch gekennzeichnet,**
**dass** eine Transportvorrichtung zum Transport der Leiterplatte (01) in, durch und aus dem Lötbereich vorgesehen ist, wobei der Aktuator (10) und der Festanschlag (12) zusammen mit der Leiterplatte (01) oder zumindest synchron zu dieser in Transportrichtung bewegbar sind.

17. Lötvorrichtung nach einem der Ansprüche 12 bis 16,
**dadurch gekennzeichnet,**
**dass** ein Transport- oder ein Leiterplattenrahmen zur Aufnahme der Leiterplatte (01) vorgesehen sind.

18. Lötvorrichtung nach Anspruch 16 oder 17,
**dadurch gekennzeichnet,**
**dass** die Ankopplung des Aktuators (10) an die Leiterplatte (01) mittelbar über die Transportvorrichtung, den Transport- oder den Leiterplattenrahmen erfolgt.

19. Lötvorrichtung nach einem der Ansprüche 16 bis 18,
**dadurch gekennzeichnet,**
**dass** die Abstützung der Leiterplatte (01) am Festanschlag (12) mittelbar über die Transportvorrichtung, den Transport- oder den Leiterplattenrahmen erfolgt oder wobei der Festanschlag durch den Transport- oder Leiterplattenrahmen gebildet wird.

## Claims

1. Method for void reduction when soldering a circuit board (01) equipped with, in particular, electrical and/or electronic components (02), wherein, during or after melting of the solder (05) located between the components (02) and the circuit board (01), said solder is subjected to a mechanical vibration, the frequency of the vibration being varied between a start frequency and an end frequency, wherein the vibration is introduced in a direction of the plane of the circuit board through direct or indirect coupling of at least one actuator (10) to at least one side edge (04) of the circuit board (01),
**characterised in that** the side edge (03) of the circuit board (01) opposite the actuator (10) is supported on a fixed stop (12).

2. Method according to claim 1,
**characterised in that**
the frequency is increased in steps or continuously between the start frequency and end frequency.

3. Method according to claim 2,
**characterised in that**
the increase in frequency takes place in a linear manner, in steps or logarithmically.

4. Method according to one of the claims 1 to 3,
**characterised in that**
the frequency range between the start frequency and end frequency lies between 0 Hz and 15 kHz.

5. Method according to one of the claims 1 to 3,
**characterised in that**
the vibration is sinusoidal.

6. Method according to one of the claims 1 to 5,
**characterised in that**
at least two cycles are carried out in succession.

7. Method according to claim 6,
**characterised in that**
the duration of a cycle amounts to between 0.1 sec and 10 sec, in particular between 1 sec and 5 sec, and the duration of all cycles amounts in total to between 10 sec and 120 sec, in particular between 10 sec and 60 sec.

8. Method according to one of the claims 1 to 7,
**characterised in that**
the vibration is substantially applied throughout the entire duration of the soldering process.

9. Method according to one of the claims 1 to 8,
**characterised in that**
the vibration is introduced indirectly via a vibration generator (10), in particular via a soldering frame or a transport device.

10. Method according to one of the claims 1 to 9,
**characterised in that**,
before the beginning of the vibration cycle, the actuator (10) rests indirectly or directly against the circuit board under an at least slight pre-tension.

11. Method according to one of the claims 1 to 9,
**characterised in that**
the vibration amplitude amounts to between 10 µm and 200 µm.

12. Soldering device for soldering a circuit board (01) equipped with, in particular, electrical and/or electronic components (02), with at least one soldering region, with at least one heating device, arranged in the soldering region, for melting the solder (05) located between the components (02) and the circuit board (01), with at least one actuator (10) for introducing mechanical vibrations into the circuit board (01) and a control device for changing the frequency of the vibrations of the actuator (10), wherein the actuator (10) can be brought into contact, indirectly or directly, with the circuit board in the region of at least a first side edge (03) of the circuit board (01), such that a vibration can be transmitted into the circuit board (01) in a direction of the plane of the circuit board,
**characterised in that** a fixed stop (12) acting in the manner of a thrust bearing is provided against which a second side edge (04) of the circuit board (01) opposite the first side edge (03) of the circuit board (01) can be brought to rest.

13. Soldering device according to claim 12,
**characterised in that**
the actuator (10) possesses a piezoelectric transducer, in particular a piezo stack transducer, a piezo fibre transducer or a piezoceramic transducer.

14. Soldering device according to claim 12,
**characterised in that**
the actuator (10) possesses a magnetostrictive transducer, a transducer made of a magnetic shape-memory alloy and/or an electromagnetic moving coil.

15. Soldering device according to one of the claims 12 to 14,
**characterised in that**
the soldering device is designed as a reflow soldering device or as a repair soldering station.

16. Soldering device according to one of the claims 12 to 15,
**characterised in that**
a transport device is provided to transport the circuit board (01) in, through and out of the soldering region, wherein the actuator (10) and the fixed stop (12) can be moved together with the circuit board (01) or at least synchronously with this in the transport direction.

17. Soldering device according to one of the claims 12 to 16,
**characterised in that**
a transport or circuit board frame is provided to hold the circuit board (01).

18. Soldering device according to claim 16 or 17,
**characterised in that**
the coupling of the actuator (10) to the circuit board (01) takes place indirectly via the transport device, the transport frame or the circuit board frame.

19. Soldering device according to one of the claims 16 to 18,
**characterised in that**
the circuit board (01) is supported on the fixed stop (12) indirectly via the transport device, the transport board or the circuit board frame or wherein the fixed stop is formed by the transport or circuit board frame.

## Revendications

1. Procédé de réduction de cavités lors du brasage d'une carte de circuits imprimés (01) équipée en particulier de composants électriques et/ou électroniques (02), dans lequel, durant ou après la fusion du métal d'apport de brasage (05) se trouvant entre les composants (02) et la carte de circuits imprimés (01), celle-ci est soumise à une vibration mécanique, la fréquence de la vibration étant modifiée entre une fréquence de départ et une fréquence finale, l'introduction de la vibration se faisant dans une direction du plan de la carte de circuits imprimés par un couplage direct ou indirect d'au moins un actionneur (10) sur au moins un bord latéral (04) de la carte de circuits imprimés (01), **caractérisé par le fait que** le bord latéral (03) de la carte de circuits imprimés (01) qui est situé respectivement en regard de l'actionneur (10) prend appui sur une butée fixe (12).

2. Procédé selon la revendication 1, **caractérisé par le fait que** la fréquence est augmentée de manière progressive ou continue entre la fréquence de départ et la fréquence finale.

3. Procédé selon la revendication 2, **caractérisé par le fait que** l'augmentation de fréquence se fait linéairement, par paliers ou de manière logarithmique.

4. Procédé selon l'une quelconque des revendications 1 à 3, **caractérisé par le fait que** la gamme de fréquence entre la fréquence de départ et la fréquence finale est comprise entre 0 Hz et 15 kHz.

5. Procédé selon l'une quelconque des revendications 1 à 3, **caractérisé par le fait que** la vibration est sinusoïdale.

6. Procédé selon l'une quelconque des revendications 1 à 5, **caractérisé par le fait que** deux cycles au moins sont effectués l'un après l'autre.

7. Procédé selon la revendication 6, **caractérisé par le fait que** la durée d'un cycle est comprise entre 0,1 sec et 10 sec, en particulier entre 1 sec et 5 sec, et que la durée de la totalité des cycles est comprise dans l'ensemble entre 10 sec et 120 sec, en particulier entre 10 sec et 60 sec.

8. Procédé selon l'une quelconque des revendications 1 à 7, **caractérisé par le fait que** l'exposition à des vibrations se fait pour l'essentiel pendant l'ensemble de la durée du processus de brasage.

9. Procédé selon l'une quelconque des revendications 1 à 8, **caractérisé par le fait que** l'introduction de la vibration se fait de manière indirecte par un générateur de vibrations (10), en particulier par un cadre de brasage ou un dispositif de transport.

10. Procédé selon l'une quelconque des revendications 1 à 9, **caractérisé par le fait que**, avant le début du cycle de vibration, ledit actionneur (10) s'applique avec une précontrainte au moins faible indirectement ou directement contre la carte de circuits imprimés.

11. Procédé selon l'une quelconque des revendications 1 à 9, **caractérisé par le fait que** l'amplitude de vibration est comprise entre 10 µm et 200 µm.

12. Dispositif de brasage pour le brasage d'une carte de circuits imprimés (01) équipée en particulier de composants électriques et/ou électroniques (02), comprenant au moins une zone de brasage, au moins un dispositif de chauffage disposé dans la zone de brasage et destiné à faire fondre le métal d'apport de brasage (05) se trouvant entre les composants (02) et la carte de circuits imprimés (01), au moins un actionneur (10) destiné à introduire des vibrations mécaniques dans la carte de circuits imprimés (01), et un dispositif de commande destiné à modifier la fréquence des vibrations de l'actionneur (10), ledit actionneur (10) pouvant être mis en appui, indirectement ou directement, sur la carte de circuits imprimés (01) au niveau d'au moins un premier bord latéral (03) de celle-ci, de telle manière qu'une vibration peut être introduite dans la carte de circuits imprimés (01) dans une direction du plan de la carte de circuits imprimés, **caractérisé par le fait qu'**une butée fixe (12) de type appui est prévue sur laquelle peut être mis en appui, tout en s'appuyant, un deuxième bord latéral (04) de la carte de circuits imprimés (01) opposé au premier bord latéral (03) de la carte de circuits imprimés (01).

13. Dispositif de brasage selon la revendication 12, **caractérisé par le fait que** l'actionneur (10) présente un transducteur piézo-électrique, en particulier un transducteur piézo-pile, un transducteur à fibre piézo-électrique ou un transducteur piézo-céramique.

14. Dispositif de brasage selon la revendication 12, **caractérisé par le fait que** l'actionneur (10) présente un transducteur magnétostrictif, un transducteur en un alliage magnétique à mémoire de forme et/ou une bobine mobile électromagnétique.

15. Dispositif de brasage selon l'une quelconque des revendications 12 à 14, **caractérisé par le fait que** le dispositif de brasage est réalisé en tant que dispositif de brasage par refusion ou en tant que station de brasage de réparation.

16. Dispositif de brasage selon l'une quelconque des revendications 12 à 15, **caractérisé par le fait qu'**un dispositif de transport est prévu pour transporter la carte de circuits imprimés (01) dans, à travers et hors de la zone de brasage, ledit actionneur (10) et ladite butée fixe (12) pouvant être déplacés, dans la direction de transport, conjointement avec la carte de circuits imprimés (01) ou au moins de manière synchrone par rapport à celle-ci.

17. Dispositif de brasage selon l'une quelconque des revendications 12 à 16, **caractérisé par le fait qu'**un cadre de transport ou un cadre de carte de circuits imprimés destiné à recevoir la carte de circuits imprimés (01) sont prévus.

18. Dispositif de brasage selon la revendication 16 ou 17, **caractérisé par le fait que** le couplage de l'actionneur (10) sur la carte de circuits imprimés (01) se fait indirectement par le dispositif de transport, le cadre de transport ou le cadre de carte de circuits imprimés.

19. Dispositif de brasage selon l'une quelconque des revendications 16 à 18, **caractérisé par le fait que** l'appui de la carte de circuit imprimés (01) sur la butée fixe (12) se fait indirectement par le dispositif de transport, le cadre de transport ou le cadre de carte de circuits imprimés, ou dans lequel la butée fixe est constituée par le cadre de transport ou le cadre de carte de circuits imprimés.
